# EUROPÄISCHE PATENTSCHRIFT

(11) **EP 1 727 280 B1**
(45) Veröffentlichungstag und Bekanntmachung des Hinweises auf die Patenterteilung: **22.07.2009**
(21) Anmeldenummer: 06114207.1
(22) Anmeldetag: 19.05.2006
(51) Int. Cl.: H03H 1/00, H05K 9/00

(54) **Gehäuse für ein EMV Filter und EMV Filter**
Housing for EMI filter and EMI filter
Boîtier pour un filtre antiparasite, filtre antiparasite

(30) Priorität: 24.05.2005 EP 05104426
(43) Veröffentlichungstag der Anmeldung: 29.11.2006
(73) Patentinhaber: SCHAFFNER EMV AG, 4542 Luterbach (CH)
(72) Erfinder: Scheller, Benedikt, 4542, Luterbach (CH); Koch, Michael, 4562, Biberist (CH); Müller, Pascal, 5000, Aarau (CH)
(74) Vertreter: P&TS Patents & Technology Surveys SA

(56) Entgegenhaltungen:
- DE-U1- 20 318 902
- JP-A- 7 272 941
- JP-A- 11 289 235
- JP-A- 11 297 544
- US-A- 5 119 266

## Beschreibung

### Technisches Gebiet

Die vorliegende Erfindung bezieht sich auf ein Gehäuse für ein EMV Filter und auf ein EMV Filter mit einem solchen Gehäuse. Die vorliegende Erfindung bezieht sich insbesondere auf ein EMV Filter zum Ensatz in Niederspannungsanlagen, d.h. in elektrischen Anlagen, die mit Spannungen von ungefähr 50V bis 1000V gespeist werden.

### Stand der Technik

Viele elektrische Vorrichtungen und Geräte sind gegen elektromagnetische Störungen durch EMV (Elektromagnetische Verträglichkeit) Filter geschützt. Diese Filter werden hauptsächlich auf den externen elektrischen Leitungen der Vorrichtung oder des Geräts, wie zum Beispiel auf den Speiseleitungen, eingesetzt. Ihr Zweck ist meistenseinerseitsdie Vorrichtung oder das Gerät vor externen elektromagnetischen Störungen zu schützen, andererseits elektromagnetische Störungen der Vorrichtung oder des Gerätsauf die externen elektrischen Leitungen und/oder auf benachbarte Vorrichtungen zu vermeiden.

EMV Filter sind oft standardisierte Bauteile, die zum Beispiel in den zu schützenden Geräten direkt integriert werden können. Sie werden hauptsächlich anhand ihrer elektrischen Spezifikationen (wie zum Beispiel Arbeitsspannung, maximal zulässiger Strom usw.) gewählt. In manchen Fällen sind ihre mechanischen Merkmale (wie zum Beispiel ihre Form und Grösse oder die Materie und die Dichtheit ihres Gehäuses) auch wichtig.

Im Stand der Technik werden EMV Filter üblicherweise in einem Gehäuse aus Metall eingebaut, über welchesdie Filterschaltung innerhalb des Gehäuses auch oft geerdet wird. Die Bauelemente (insbesondere die elektronischen Bauelemente) des Filterswerden im Gehäuse zum Beispiel durch Vergiessen, Löten, Schweissen, Schrauben, Scherbruch, usw. befestigt. Durchführungsklemmen reichen dann meistensdurch die Wände des Gehäuses hindurch, um einen elektrischen Kontakt zwischen der elektrischen Schaltung des Filtersinnerhalb des Gehäuses und den Leitern der zu entstörenden elektrischen Leitung ausserhalb desselben zu erlauben.

Im Stand der Technik werden für EMV Filter oft rechteckige Gehäuse benützt, welche bestimmte vordefinierte Abmessungen und Klemmentypen aufweisen. En Nachteil von solchen Gehäusen ist, dassdie Abmessungen der Gehäuse immer leicht grösser alsder eigentliche Platzbedarf für die Filterschaltung gewählt werden muss. Müssen die Abmessungen desfertigen Filters minimiert werden, dann müssen oft Gehäuse mit speziell angepassten Abmessungen hergestellt werden, wasden Preisdes Gehäusesund somit des Filterserhöht.

Die Herstellung von solchen Gehäusen ist ausserdem relativ teuer. Sie werden zum Beispiel ausgestanztem und gebogenem Metallblech hergestellt, wasteuere und schlecht automatisierbare Biege- und möglicherweise Lötvorgänge mit sich bringt. Im Stand der Technik werden die metallenen rechteckigen Gehäuse auch in Pressformen geformt, was einfach, automatisch und relativ schnell durchgeführt werden kann. Eswird aber eine teuere Pressform für jede Gehäusegrösse benötigt. Die rechteckigen Gehäuse des Standes der Technik aus Metallblech sind ausserdem mechanisch sehr empfindlich. Um festere Gehäuse zu schaffen, wird üblicherweise die Wanddicke vergrössert, was aber den Preis der Gehäuse entsprechend erhöht.

Ausserdem müssen die Gehäuse an die in den Filtern eingesetzten Durchführungsklemmen angepasst werden, indem üblicherweise Öffnungen mit bestimmten Formen und Abmessungen ausgespart werden. Weist ein bestimmtes Filter zwei verschiedenen Typen von Klemmen auf (weil esbeispielsweise in verschiedenen Ländern mit unterschiedlichen Regeln verkauft wird) dann müssen unterschiedlichen Gehäuse für die gleiche Filterschaltung vorbereitet werden, wasdie Lagerdisposition beim Filterhersteller wesentlich erschwert.

JP11289235 offenbart einen Filter für eine Kommunikationslinie.

### Darstellung der Erfindung

En Ziel der Erfindung ist, ein Gehäuse für EMV Filter vorzuschlagen, welches mühelos an unterschiedlichen Filterschaltung sgrössen anpassbar ist.

En weiteres Ziel der Erfindung ist, ein Gehäuse für EMV Filter vorzuschlagen, dessen elektrischen En- und Ausgangsanschlusselemente einfach auswechselbar sind, damit das EMV Filter mühelos zum Anschluss von beliebigen Kabelanschlussarten angepasst werden kann.

En weiteres Ziel der Erfindung ist, ein Gehäuse für EMV Filter vorzuschlagen, welchesbilliger ist als die Gehäuse für EMV Filter im Stand der Technik.

En weiteres Ziel der Erfindung ist, ein Gehäuse für EMV Filter vorzuschlagen, welches mechanisch stabiler ist als die Gehäuse für EMV Filter im Stand der Technik.

Noch ein weiteresZiel der Erfindung ist, ein EMV Filter vorzuschlagen, welches modular aufgebaut und leicht an bestimmte Einsatzbedingungen angepasst werden kann.

Diese Ziele werden durch ein Gehäuse für EMV Filter mit den Merkmalen desentsprechenden unabhängigen Anspruchsund durch ein EMV Filter mit einem solchen Gehäuse entsprechend dem Anspruch 15 erreicht.

Erreicht werden diese Ziele insbesondere durch ein Gehäuse für ein EMV Filter zum Einsatz in einer Niederspannungsanlage, mit einer Abdeckung, welche zumindest teilweise ausden zwei Längsseiten und einer Oberseite des Gehäuses gebildet wird sowie zwei Endstücken, welche mindestensteilweise die zwei entgegengesetzten Stirnseiten des Gehäuses bilden, wobei die Endstücke elektrische Klemmen zum Anschlussvon elektrischen Leitern einer zu entstörenden elektrischen Leitung umfassen, und durch ein EMV Filter mit einer Filterschaltung und ein solches Gehäuse.

### Kurze Beschreibung der Figuren

Die Erfindung wird anhand der beigefügten Figuren näher erläutert, wobei zeigen
- Fig. 1: eine Seitenansicht eines Filters gemäss einer bevorzugten Ausführungsform der Erfindung,
- Fig. 2: eine Frontansicht des Filters der Fig. 1,
- Fig. 3: eine Obenansicht des Filters der Fig. 1,
- Fig. 4: eine perspektivische Ansicht des Filters der Fig. 1.
- Fig. 5: eine Frontansicht der Abdeckung des Filters der Fig. 1 und
- Fig. 6-8: eine perspektivische Ansicht eines Filters gemäss einer anderen Ausführungsform der Erfindung.

### Wege zur Ausführung der Erfindung

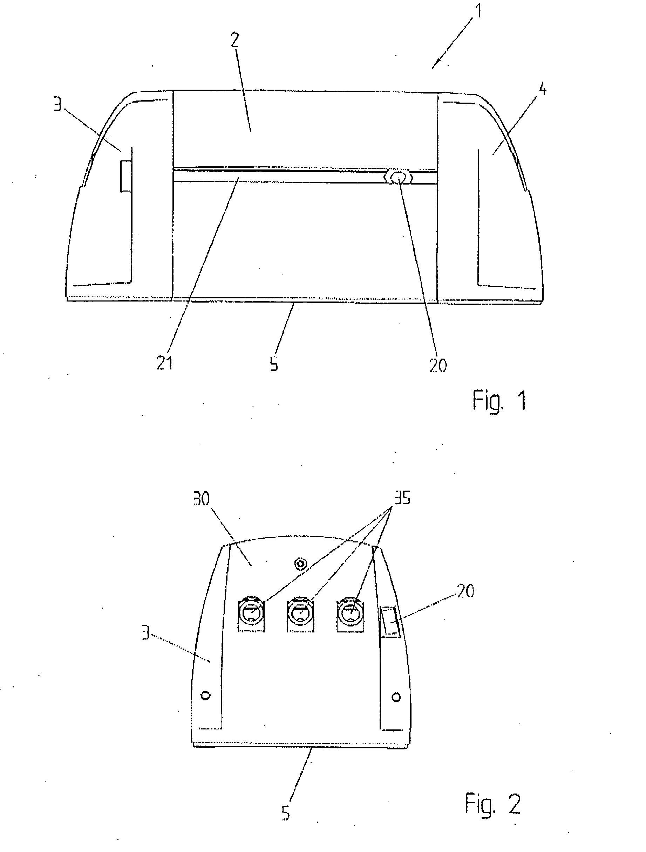

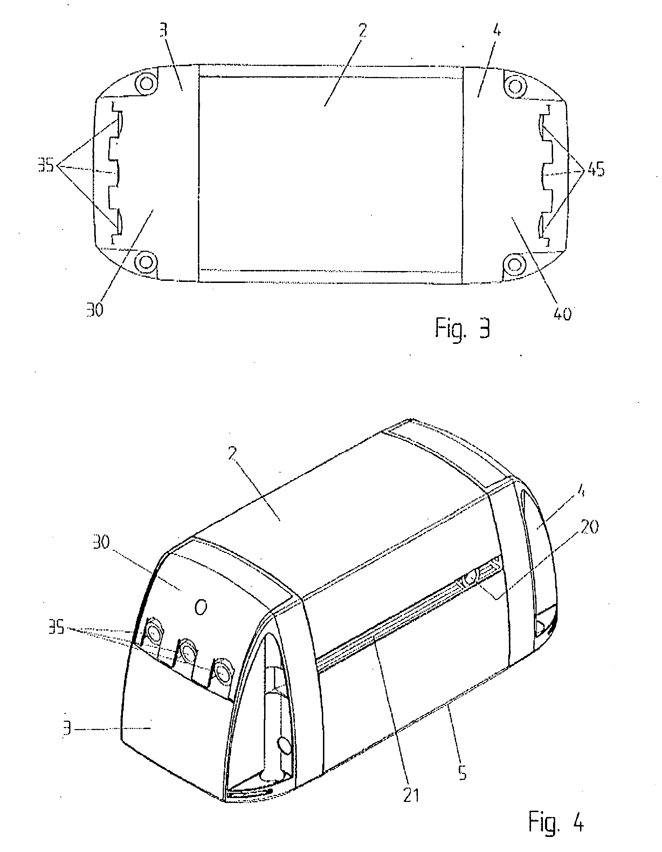

In einer bevorzugten Ausführungsform der Erfindung, welche auf den Figuren 1 bis4 dargestellt ist, umfasst dasEMV Filter ein Gehäuse 1, daseine nicht dargestellte Filterschaltung umschliesst. Im dargestellten Beispiel ist dasEMV Filter zum Einsatz auf einer dreiphasigen elektrischen Leitung vorgesehen. In diesem Fall weist das EMV Filter drei Eingangsklemmen 35 und drei Ausgangsklemmen 45 zum Anschlussder drei nicht dargestellten Phasenleiter einer elektrischen Leitung auf. Die Eingangsklemmen 35 sind vorzugsweise auf einer Seite desGehäuses 1 angeordnet, während die Ausgangsklemmen 45 auf der entgegengesetzten Seite liegen. Die En- und Ausgangsklemmen 35, 45 sind innerhalb des Gehäuses 1 mit bestimmten Kontaktpunkten der Filterschaltung elektrisch verbunden, um die gewünschte Filterung der auf der elektrischen Leitungen vorhandenen Störungen zu erzielen.

Das Gehäuse 1 umfasst eine Abdeckung 2, welche die Filterschaltung auf drei Seiten mindestensteilweise umschliesst. Vorzugsweise bildet die Abdeckung 2 den Hauptteil der Längsseiten und der Oberseite des Gehäuses 1. In einer bevorzugte Ausführungsform der Erfindung ist die Abdeckung 2 elektrisch leitend, zum Beispiel metallisch (beispielsweise aus Aluminium) und dient zur Erdung der Filterschaltung, indem sie einerseits mit der Erde der Filterschaltung und andererseits mit einer elektrischen Senke ausserhalb desEMV Filterselektrisch verbunden ist. Die Abdeckung aus Aluminium oder auseinem anderen Metall bietet auch gute Kühlmöglichkeiten. Abdeckungen aus Kunststoff sind aber im Rahmen der Erfindung auch möglich.

Die elektrisch leitende Abdeckung 2 kann einen Erdanschluss 20 zum Anschluss des Erdleiters der zu entstörenden elektrischen Leitung umfassen. Im dargestellten Ausführungsbeispiel besteht der Erdanschluss 20 auseiner Schraubenmutter, die in einer Nut 21 an einer Aussenseite der Abdeckung 2 so eingeklemmt wird, dasssie sich nur lateral bewegen kann. Wird ein Erdleiter mit einer Schraube direkt oder über einen Kabelschuh an die Abdeckung 2 geschraubt, dann ist er mit der Abdeckung 2 elektrisch verbunden. Die Leitung wird also über dasEMV Filter geerdet, falls die Abdeckung 2 selber geerdet ist. Vorzugsweise kann sich die Schraubenmutter entlang der Schiene 21 bewegen, um sich der Länge und/oder der Lage des anzuschliessenden Erdleitersanzupassen. In einer bevorzugten Ausführungsform ist die Abdeckung 2 symmetrisch und besitzt einen ähnlichen Erdanschlussauf der entgegengesetzten Seite. En Anschlussan der inneren Seite der Abdeckung 2, direkt an der Grundplatte 5 oder mit einer Klemme, ist aber auch möglich.

Der Erdanschlusskann auch über eine Klemme, eine Schraube, Bolzen, usw. Stirnseitig direkt an die weiter unter beschriebene Grundplatte 5 befestigt sein, und dieseinseitig oder an beiden Enden der Grundplatte.

DasGehäuse 1 umfasst weiter eine Grundplatte 5 und zwei Endstücke 3, 4. Die Grundplatte 5 bildet mindestenseinen Teil der Unterseite des Gehäuses 1, währenddessen die Endstücke 3, 4 mindestensje einen Teil einer Stirnseite bilden. Die Endstücke 3, 4 tragen die Ein- und Ausgangsklemmen 35, 45, indem vorzugsweise ein Endstück 3 die Eingangsklemmen 35 trägt, währenddessen dasentgegengesetzte Endstück 4 die Ausgangsklemmen 45 trägt. Im dargestellten Beispiel werden die elektrischen Ein- und Ausgangsklemmen 35, 45 mit einem elektrisch isolierenden Deckel 30, 40 abgedeckt, um zu vermeiden, dasssie während des Betriebsdes EMV Filtersversehentlich berührt werden. Der Deckel 30, 40 besteht zum Beispiel aus Kunststoff und ist vorzugsweise durchsichtig, um eine schnelle visuelle Kontrolle der Klemmen 35, 45 während des Betriebsdes Filters zu ermöglichen.

Im Rahmen der Erfindung können die En- und Ausgangsklemmen 35, 45 unterschiedlichen Typssein. Eskönnen eigentlich alle Arten von elektrischen Anschlüssen eingesetzt und in den Endstücken des Gehäuses eingesetzt werden. Eswerden vorzugsweise federartige Anschlussklemmen verwendet, bei welchen Feder unverlierbare Schrauben und auf die Kabel wirkende Druckkabel offen halten, wobei die Klemme geschraubt werden muss, um Drähte, Litzen, offene Kabelschuhe oder Ringkabelschuhe anzuschliessen. Es können aber auch Steckdosen als Klemmen verwendet werden.

Die Auswahl eines bestimmten elektrischen Anschlusses hängt üblicherweise von den Einsatzbedingungen desEMV Filtersund/oder von gewissen gesetzlichen Vorschriften ab. Vorzugsweise werden also verschiedene Endstücke 3, 4 mit verschiedenen Anschlusstypen vorgesehen, wobei alle Endstücke die gleiche Schnittstelle zur Abdeckung 2 und zur Filterschaltung besitzen. Somit kann beim Aufbau des Filters der gewünschte Anschlusstyp einfach eingesetzt werden, indem die entsprechenden Endstücke gewählt werden. Mit dem Gehäuse 1 der Erfindung kann ausserdem dasEMV Filter schnell und einfach an andere Bedingungen und/oder Vorschriften angepasst werden, indem ein Endstück 3 oder 4 mit einem bestimmten Typ von elektrischen Anschlüssen durch ein anderes Endstück mit anderen elektrischen Anschlüssen ersetzt wird.

Im Rahmen der Erfindung können also die Endstücke zum Beispiel so gestaltet sein, dasssie als elektrische Anschlüsse eine oder mehrere übliche Normsteckdosen umfassen, welche Steckern der zu entstörenden Leitung entsprechen. In weiteren Ausführungsformen der Erfindung sind die elektrische Anschlüsse Kabelausführungen mit bestimmten Endsteckern und/oder Klemmen, oder Kombinationen von Klemmen und Steckdosen und/oder weiteren Anschlusselementen, welche an entsprechende Kombinationen von Anschlüssen auf der zu entstörenden Leitung angepasst sind.

Die Endstücke 3, 4 bestehen mindestensteilweise auseinem elektrisch nicht leitenden Material, zum Beispiel aus Kunststoff. Die elektrischen Klemmen 35, 45 sind vorzugsweise von der Abdeckung 2 isoliert durch das nicht leitende Material des entsprechenden Endstücks3, 4. Auf der Innenseite des Filterssind die Klemmen 35, 45 mit der Filterschaltung elektrisch angeschlossen, um den elektrischen Kontakt zwischen den äusseren elektrischen Leitern und der Filterschaltung zu gewährleisten.

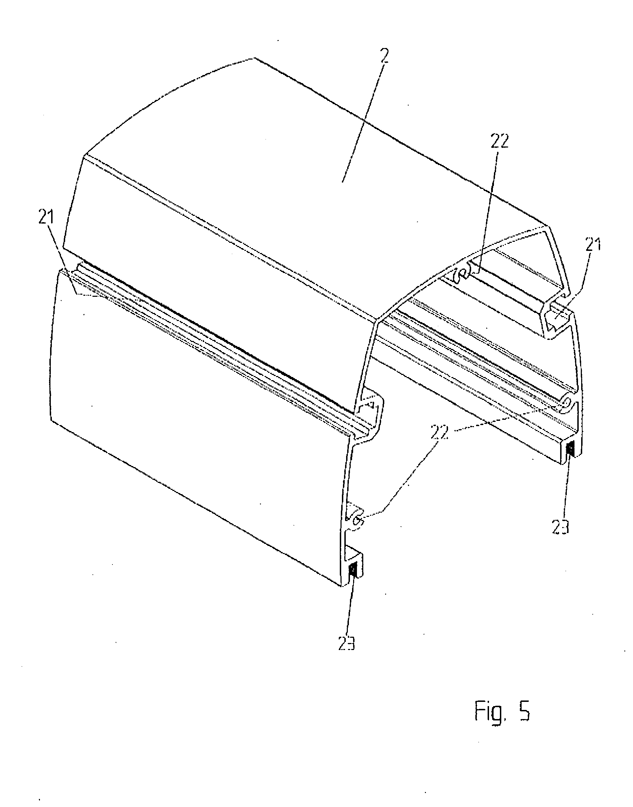

In einer bevorzugten Ausführungsform wird die hier nicht dargestellte Filterschaltung beispielsweise auf der Grundplatte 5 befestigt. Die Filterschaltung wird zum Beispiel teilweise auf einer gedruckten Schaltung und/oder auf einem Gerüst aufgebaut, welche auf der Grundplatte 5 befestigt, beispielsweise geschraubt werden. Die Leiterplatte kann auch senkrecht montiert werden, oder eskönnen mehrere senkrechte Leiterplatten verwendet werden. Die Abdeckung 2 wird dann über die Filterschaltung auf die Grundplatte 5 gestellt und zum Beispiel ebenfalls geschraubt. Vor oder nach der Befestigung der Abdeckung 2 werden noch die Endstücke 3, 4 mit den integrierten elektrischen Klemmen 35, 45 eingesetzt. Die elektrischen Verbindungen zwischen den Klemmen 35, 45 und der Filterschaltung werden vorzugsweise beim Einsetzen der Endstücke 3, 4 aufgebaut, zum Beispiel mittelszusätzlichen flexiblen elektrischen Leitern oder direkt durch den Kontakt eines Endstückes der jeweiligen Klemmen 35, 45 mit bestimmten Kontaktpunkten der Filterschaltung. Die Endstücke 3, 4 werden vorzugsweise ebenfalls an der Grundplatte 5 und/ oder an der Abdeckung 2 befestigt (zum Beispiel geschraubt). In einer bevorzugten Ausführungsform, umfasst die Abdeckung Befestigungsmittel 22, 23 (Fig. 5), welche eine direkte Befestigung der Endstücke und/oder der Grundplatte an der Abdeckung (zum Beispiel mit Schrauben) ermöglichen.

In einer bevorzugten Ausführungsform besteht die Abdeckung 2 auseinem Profil, welches auf die gewünschte Länge zugeschnitten wurde (Fig. 5). Die Abdeckung 2 ist beispielsweise ein gepresstes und/oder gefaltetesAluprofil. Die Abdeckung 2 kann also relativ schnell und billig in grossen Mengen hergestellt werden, indem das Profil kontinuierlich in grosser Länge hergestellt und erst später auf die gewünschte Länge zugeschnitten werden kann. Somit können auf einfache Weise Familien von Filtergehäusen mit unterschiedlichen Längen aber gleichen Endstücken hergestellt werden.

Die Befestigungsmittel 22, 23 werden vorzugsweise direkt im Profil integriert, damit sie bei jeder Abdeckungslänge vorhanden sind. Im Rahmen der Erfindung kann aber die Abdeckung 2 auch auseinem anderen gepressten und/oder geformten Material bestehen. In einer Ausführungsform besteht die Abdeckung 2 zum Beispiel aus Kunststoff, um zum Beispiel der Filterschaltung einen besseren elektrischen Schutz zu gewährleisten. Da die Abdeckung 2 aber dann nicht leitend ist, mussdie Erdung der Filterschaltung über andere Elemente des Gehäuses 1, zum Beispiel über die Grundplatte 5, gewährleistet werden.

In den in den Fig. 1 bis4 dargestellten Ausführungsformen sind die Ein- und Ausgangsklemmen 35, 45 parallel zur Längsachse des Gehäuses 1 orientiert. Im Rahmen der Erfindung können aber die En- und Ausgangsklemmen 35, 45 anders orientiert werden, um zum Beispiel dem Einsatz des EMV Filterszu vereinfachen und/oder um seinen Platzbedarf zu verkleinern.

Eine Orientierung der Ein- und Ausgangsklemmen 35, 45 senkrecht zur Längsachse des Gehäuses 1 ist zum Beispiel denkbar. Eine solche Anordnung der En- und Ausgangsklemmen 35,45 ist zum Beispiel dann besondersvorteilhaft, wenn dasEMV Filter mit weiteren Bauelementen einer elektrischen Anlage in Reihe angeordnet wird.

Im dargestellten Beispiel umfasst die nicht dargestellte Grundplatte des Gehäuses 1 Befestigungselemente, welche die Befestigung des EMV Filters auf einer Schiene ermöglichen. Vorzugsweise ist die Schiene elektrisch leitend und dient auch zur Erdung der Filterschaltung durch die Grundplatte 5. Die Klemmen 35, 45 sind vorzugsweise so angeordnet, dass die Eingangsklemmen 35 von einer Seite des EMV Filters und die Ausgangsklemmen 45 von der entgegengesetzten Seite her anschliessbar sind. Mit dieser Anordnung wird der Platzbedarf desEMV Filters für einen Einsatz auf einer Schiene optimiert, wenn die senkrecht angeordneten Klemmen keinen zusätzlichen Platz für die angeschlossenen elektrischen Leiter entlang der Schiene brauchen. Die nächsten Bauelemente, welche auch auf der Schiene montiert werden, können also sehr nah am EMV Filter platziert werden. Mit einer solchen Anordnung wird auch die Wartung des Filters erleichtert, weil die Klemmen 35, 45 leicht zugänglich bleiben, selbst wenn weitere Bauelemente auf der Schiene neben dem EMV Filter befestigt sind.

Eine Befestigung der Endstücke 3, 4 auf der entgegengesetzten Stirnseite des Gehäuses 1 kann auch eingesetzt werden, um die En- und Ausgangsklemmen 35, 45 in die entgegengesetzte Richtung zu orientieren.

Die Endstücke 3, 4 bestehen vorzugsweise hauptsächlich aus Kunststoff. Die elektrischen Klemmen 35, 45 werden somit insbesondere von der (zum Beispiel metallenen) Abdeckung 2 isoliert. In einer Ausführungsform der Erfindung wird der Kunststoff geformt (zum Beispiel in eine Form gespritzt) und dann werden die Elemente, welche die elektrischen Klemmen 35, 45 bilden, in bestimmten Aussparungen des Kunststoffteilsplatziert. In einer anderen Ausführungsform der Erfindung wird der Kunststoff um die Klemmen 35, 45 herum oder mindestensein Teil davon geformt. Die Klemmen 35, 45 sind somit im Endstück 3', 4 selber völlig integriert und können vorzugsweise nicht entfernt werden, ohne dass das Endstück 3, 4, zerstört wird.

Im Inneren des Gehäuses 1 werden die elektrischen Verbindungen zwischen den jeweiligen Endstücken 3, 4 und den entsprechenden Kontaktpunkten der Filterschaltung zum Beispiel mit flexiblen Leitern gewährleistet. Die Leiter sind dann an beiden Enden befestigt, zum Beispiel gelötet oder geschraubt. In einer anderen Ausführungsform umfassen die elektrischen Klemmen 35, 45 feste Elemente zum Beispiel metallene Stangen, die an der Innenseite jedes Endstücks3, 4, liegen. Wenn das Endstück 3, 4, korrekt sitzt, kommen dann diese Leiter in elektrischen Kontakt mit der Filterschaltung, zum Beispiel indem sie je einen bestimmten Kontaktpunkt der Schaltung berühren oder indem sie in einem Stecker der Filterschaltung eingesteckt werden.

In die Endstücke 3, 4 können ausserdem noch andere Elemente alsdie Klemmen 35, 45 integriert werden. Diese Elemente können zum Beispiel rechtliche Vorschriften erfüllen und/oder sie ermöglichen weitere elektrische Funktionen. In einem nicht dargestellten Ausführungsbeispiel trägt ein Endstück des Gehäuses einen Verteiler, damit mehrere elektrische Leiter an die Ausgangsklemme einer einzigen Phase angeschlossen werden können. Verteiler werden oft am Ausgang von EMV Filtern eingesetzt, zum Beispiel wenn die filtrierte elektrische Leitung an mehrere weitere parallele Bauelemente der Anlage geleitet werden muss. Solche Verteiler sind vom EMV Filter getrennte Bauelemente, welche Platz und zusätzliche elektrische Verbindungen benötigen. Ist ein Verteiler direkt im Endstück integriert, dann werden die elektrischen Verbindungen zwischen der jeweiligen Klemme und dem Verteiler im Endstück beim Aufbau desselben aufgebaut. Die Anschlusselemente des Verteilers, die zum Beispiel sogenannte Faston Klemmen sind, sind dann direkt auf dem Endstück anschliessbar. Vorzugsweise sind die unbenutzten Anschlusselemente durch einen Deckel abgedeckt, damit sie nicht versehentlich berührt werden.

Im Rahmen der Erfindung können auch weitere Elemente in die Endstücke integriert werden. Im Falle einer Anwendungen des EMV Filters der Erfindung bei sehr hohen Frequenzen, können zum Beispiel Ferritelemente in einem oder beiden Endstücken integriert werden, um bestimmte Frequenzen direkt bei den En- und/oder Ausgangsanschlusselementen des Filterszu dämpfen.

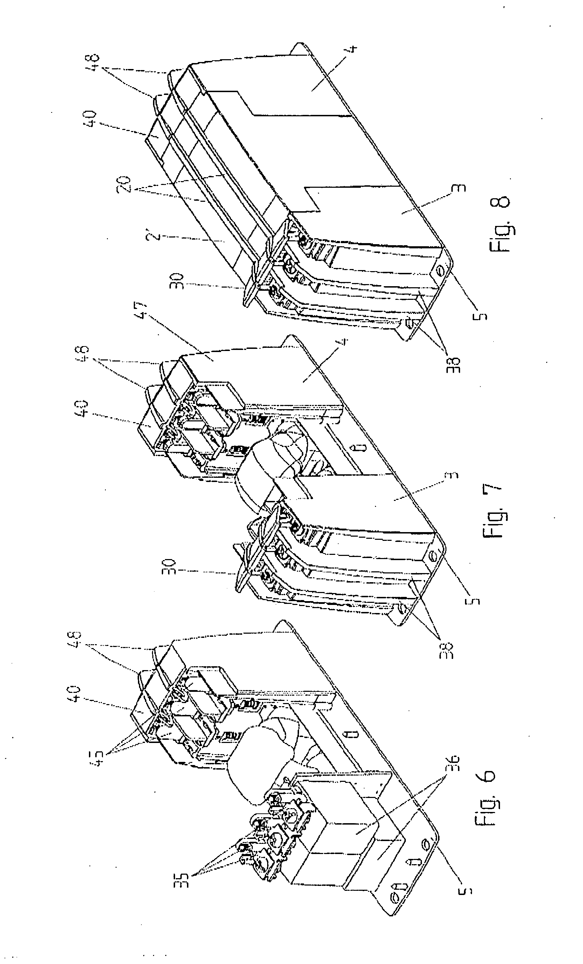

Die Figuren 6 bis 8 zeigen eine andere Ausführungsvariante der Erfindung. Das markante an dieser Variante ist unter anderem die Anordnung der Endstücke 3, 4, die einen Deckel 37 bzw. 47 über den inneren Elementen 36 (nicht dargestellt) aufweist. Der Deckel 37 ist auf der Figur 6 abwesend um die oben erwähnten, hier schematisch dargestellten inneren mechanischen und/oder elektrischen Elemente des Endstücks zu zeigen. Beide Deckel können separat und unabhängig von den inneren Elementen 35 und von den Klemmen 35 demontiert werden. Die inneren Elemente werden direkt und/oder über eine senkrechte Platte an der Grundplatte 5 befestigt, und die Deckel an die Grundplatte 5 und/oder an die innere Elemente lösbar befestigt, zum Beispiel geschraubt oder geklipst.

Die Aussenseite der Endstücke 3 und 4 weisen ausserdem elektrisch isolierende hervorstehende Rippen 38 bzw. 48 auf, die sich zur Erhöhung des Kriechwegszwischen den Anschlusselementen 35, 45 befinden. Durch diese Rippen wird auch eine mechanische Verstärkung der Endstücke erreicht. Im dargestellten Beispiel erstrecken sich zwei Rippen parallel zueinander, senkrecht von der Grundplatte 5 biszur oberen Seite des Endstücks, wo die Klemmen angeordnet sind.

Beide Endstücke 3, 4 weisen ausserdem einen einteiligen, durchsichtigen, aufklappbaren zweiten Deckel 30, 40 auf, der alle Anschlusselemente 35 bzw. 45 überdeckt und selbst mit Rippen zur Trennung der Anschlusselemente aufgestattet ist. Die Rippen deszweiten Deckels30, 40 erstrecken sich biszum Ende der entsprechen Rippen 38, 48 des Deckels. Federartige Mittel oder Teile des Gehäuses halten vorzugsweise den zweiten Deckel 30, 40 geschlossen.

In der Variante der Figuren 6 bis8 besteht die Abdeckung 2' aus Kunststoff. Die obere Seite der Abdeckung 2' weist auch zwei Verstärkungsrippen 20 in der Verlängerung der Rippen 38, 48 desDeckels3, 4 auf. Zusätzliche oder tiefere Rippen können auch vorgesehen werden, einschliesslich Rippen orthogonal zu den longitudinalen dargestellten Rippen und/ oder Rippen an den senkrechten Wände der Abdeckung 2' und/oder Rippen an den Innenseiten der Abdeckung.

Die Abdeckung wird in diesem Beispiel an die Grundplatte 5 geschraubt. Eskann auch (oder zusätzlich) ein Klipsen der Abdeckung 2' durch elastische Deformierung von Teilen der Abdeckung und/oder der Endstücke vorgesehen werden.

Die Abdeckung 2' kann auch wasserdicht, oder vor Spritzern sicher, mit den Endstücken und mit der Grundplatte verbunden sein; für eine bessere Abdichtung können auch Dichtungen vorgesehen werden.

Insbesondere bei Varianten mit einer Abdeckung aus Kunststoff, wie die Variante der Figuren 6 bis8, kann der Erdanschlussan einem oder beiden Enden der Grundplatte mittels Schrauben oder Bolzen vorgenommen werden. Alternativ kann der Erdanschlussauch ganz entfallen, und nur über die Grundplatte erfolgen. Dazu dürfte ein Hinweis nötig sein, dassdie Grundplatte auf zuverlässig geerdete Träger geschraubt oder befestigt werden muss.

## Patentansprüche

1. Gehäuse (1) für ein EMV Filter zum Einsatz in einer Niederspannungsanlage, mit:
- einer Abdeckung (2), welche zumindest teilweise die zwei Längsseiten und eine Oberseite des besagten Gehäuses (1) bildet,
- zwei Endstücken (3, 3', 4, 4'), welche mindestens teilweise die zwei entgegengesetzten Stirnseiten des besagten Gehäuses (1) bilden,
wobei die besagten Endstücke (3, 3', 4, 4') elektrische Anschlusselemente (35, 45) zum Abschluss von elektrischen Leitern (83, 84) einer zu entstörenden elektrischen Leitung umfassen
**dadurch gekennzeichnet, dass**
die besagte Abdeckung (2) Befestigungsmittel (22) umfasst, um eine Befestigung der besagten Endstücke (3, 3', 4, 4') an die besagten Abdeckung (2) zu ermöglichen, und
mindestens eines der besagten Endstücke (3, 3', 4, 4') einen einteiligen, durchsichtigen Deckel (30, 40) aufweist, der alle Anschlusselemente (35, 45) überdeckt und mit Rippen zur Trennung der Anschlusselemente (35, 45) ausgestattet ist.

2. Gehäuse (1) gemäss dem vorherigen Anspruch, wobei die besagte Abdeckung (2) elektrisch leitend ist.

3. Gehäuse (1) gemäss dem vorherigen Anspruch, wobei die besagten Endstücke (3, 3', 4, 4') mindestensteilweise elektrisch isolierend sind, um eine elektrische Isolierung der besagten Anschlusselemente (35, 45) gegenüber der besagten Abdeckung (2) zu gewährleisten.

4. Gehäuse gemäss dem vorherigen Anspruch, wobei die besagten Endstücke (3, 3',4,4') mindestens teilweise aus Kunststoff bestehen.

5. Gehäuse gemässeinem der Ansprüche 2 bis 4, wobei die besagte Abdeckung (2) mindestens einen elektrischen Erdanschluss (20) zum Anschluss von mindestens einem Erdleiter umfasst.

6. Gehäuse (1) gemässeinem der vorherigen Ansprüche, wobei die Abdeckung (2) aus einem länglichen dreiseitigen Profil gebildet wird.

7. Gehäuse (1) gemäss dem vorherigen Anspruch, wobei die Abdeckung (2) auseinem dreiseitigen Profil aus Aluminium gebildet wird.

8. Gehäuse (1) gemäss einem der Ansprüche 7 oder 8, wobei das besagte Profil ein gepresstes Profil ist.

9. Gehäuse (1) gemäss Anspruch 1, wobei die besagte Abdeckung (2) elektrisch isolierend ist.

10. Gehäuse gemässeinem der Ansprüche 1 bis 10, wobei die besagten Endstücke (3, 3', 4, 4') elektrisch isolierende hervorstehende Rippen zwischen den Anschlusselementen zur Erhöhung des Kriechwegs aufweisen.

11. Gehäuse gemäss einem der Ansprüche 1 bis 10, wobei der einteilige, durchsichtige Deckel (37, 47) aufklappbar ist.

12. Gehäuse (1) gemäss Anspruch 11, wobei die Anordnung der Endstücke (3, 4) einen Deckel (37, 47) über inneren Elementen (36) aufweist.

13. Gehäuse (1) gemäss einem der vorherigen Ansprüche, mit einer länglichen Grundplatte (5), wobei je eines der beiden benannten Endstücke auf jeder länglichen Ende der Grundplatte montiert ist, wobei elektronische Bauteile zwischen den beiden benannten montiert sind und von der benannten Abdeckung abgedeckt wird.

14. Gehäuse gemässAnspruch 13, wobei einesder besagten Endstücke (3, 3', 4, 4') elektrische Anschlusselemente (35, 45) aller eingangsseitigen Phasen des Filters und daszweite besagte Endstück elektrische Anschlusselemente (35, 45) aller ausgangsseitigen Phasen des Filters umfasst.

15. Gehäuse (1) gemässeinem der Ansprüche 13 bis 14, wobei die besagte Grundplatte (5) aus Metall besteht, wobei eine thermische Brücke zwischen mindestens einem wärmeerzeugenden Bauteil des Filters und der besagten Grundplatte vorgesehen ist.

16. Gehäuse (1) gemässeinem der Ansprüche 13 bis 14, wobei ein Erdanschlussdirekt an die besagte Grundplatte (5) erfolgt.

17. Gehäuse (1) gemässeinem der vorherigen Ansprüche, mit Befestigungsmitteln zur Befestigung des besagten EMV Filters auf einer Schiene (9).

18. EMV Filter zum Ein satz auf einer elektrischen Leitung in einer Niederspannungsanlage mit:
- einer Filterschaltung,
- einem Gehäuse (1) gemässeinem der vorherigen Ansprüche, um die besagte Filterschaltung mindestens teilweise einzuschliessen,
wobei die besagten elektrischen Anschlusselemente (35, 45) mit der besagten Filterschaltung innerhalb des besagten Gehäuse (1) elektrisch verbunden sind.

## Claims

1. Housing (1) for a EMC filter for the use in a low voltage assembly with
• a cover (2), which forms at least partially the two longitudinal sides and the top of said housing (1),
• two end pieces (3, 3', 4, 4'), which form at least partially the two opposite gable ends of said casing (1),
• wherein said end pieces (3, 3', 4, 4') comprise electrical connecting elements (35, 45) for connecting of electrical connectors (83, 84) of an electrical line, in which noise should be reduced,
**characterised in that**
said cover (2) comprise fastening means (22) to allow to fasten said end pieces (3, 3',4,4') to said cover (2), and
at least one of said end pieces (3, 3', 4, 4') comprises an one-piece transparent cap (30, 40), which covers all connection elements (35, 45) and which is equipped with rips for separating said connection elements (35, 45).

2. Housing (1) according to the preceding claim, wherein said cover (2) is electrically conducting.

3. Housing (1) according to preceding claim, wherein said end pieces (3, 3',4,4') are at least partially electrical isolating to guarantee a electrical isolation of the connection elements (35, 45) vis-à-vis said cover (2).

4. Housing (1) according to preceding claim, wherein said end pieces (3, 3',4,4') consists at least partially from a plastic.

5. Housing according to any of the claims 2 to 4, wherein said cover (2) comprises at least one electrical ground connection (20) for connecting at least one ground conductor.

6. Housing (1) according to one of the preceding claims, wherein said cover (2) is build from a longitudinal profile having three sides.

7. Housing (1) according to the preceding claim, wherein said cover (2) is build from an aluminium profile having three sides.

8. Housing (1) according to claim 7 or 8, wherein said profile is a pressed profile.

9. Housing (1) according to claim 1, wherein said cover (2) is electrically isolating.

10. Housing according to any of the claim 1 to 9, wherein said end pieces (3, 3', 4, 4') present electrical isolating protruding rips between the connections elements to increase the creepage path.

11. Housing according to any of the claim 1 to 10, wherein the one-piece cap (37, 47) can be flip opened.

12. Housing (1) according to claim 11, wherein the arrangement of the end pieces (3, 4) presents a cap (37, 47) over the inner elements (36).

13. Housing (1) of one of the preceding claim with a longitudinal base plate (5), wherein each of both end pieces is assembled to each longitudinal end of the base plate, wherein electronic elements are assembled there between and are covered by said cover.

14. Housing according to claim 13, wherein one of the end pieces (3, 3', 4, 4') comprises electrical connection elements (35, 45) of all input sided phases of the filter and the second end piece comprises electrical connection elements (35, 45) of all output sided phases of the filter.

15. Housing (1) according to one of claim 13 or 14, wherein said base plate (5) consists of metal, wherein a thermal bridge is provided between at least a heat producing part of the filter and said base plate.

16. Housing (1) according to one of claim 13 or 14, wherein a ground connection is directly connected to said base plate (5).

17. Housing (1) according to any of the preceding claims with fastening means to fasten said EMC filter on a guiding (9).

18. EMC Filter for the use in an electrical line of a low voltage assembly with
• a filter circuit,
• a housing (1) according to any of the preceding claims to enclose said filter circuit at least partially,
• wherein said electrical connection elements (35, 45) are connected electrically with said filter circuit inside said housing (1).

## Revendications

1. Boîtier (1) pour un filtre antiparasite pour utilisation dans un appareillage à basse tension avec
• un couvercle (2), qui forme au moins partiellement les deux longueurs et le dessus dudit boîtier (1),
• deux abouts (3, 3',4,4'), qui forment au moins partiellement les deux faces opposées dudit boîtier (1), lesdits abouts (3, 3', 4, 4') comportant des connexions électriques (35, 45) pour connecter les connecteurs électriques (83, 84) d'une ligne électrique dont on veut réduire le bruit,
**caractérisé en ce que**
ledit couvercle (2) comprend des moyens de fixation (22) pour accrocher lesdits abouts (3, 3', 4, 4') audit couvercle (2), et que
au moins un desdits abouts (3, 3', 4, 4') comporte un capot transparent en une-pièce (30, 40), qui couvre toutes les connexions électriques (35, 45) et qui est doté de nervures pour séparer les connexions électriques (35, 45).

2. Boîtier (1) selon la revendication précédente, selon lequel ledit couvercle (2) est électro-conducteur.

3. Boîtier (1) selon la revendication précédente, selon lequel lesdits abouts (3, 3', 4, 4') sont au moins partiellement des isolants électriques pour garantir l'isolation électrique des connexions électriques (35, 45) vis-à-vis dudit couvercle (2).

4. Boîtier selon la revendication précédente, selon lequel lesdits abouts (3, 3', 4, 4') sont constitués au moins partiellement de plastique.

5. Boîtier selon l'une des revendications 2 à 4, selon lequel ledit couvercle (2) comprend au moins une connexion de mise à terre (20) pour connecter au moins un conducteur de terre.

6. Boîtier (1) selon l'une des revendications précédentes, selon lequel ledit couvercle (2) est construit dans un profilé longitudinal à trois faces.

7. Boîtier (1) selon la revendication précédente, selon lequel ledit couvercle (2) est construit dans un profilé en aluminium à trois faces.

8. Boîtier (1) selon l'une des revendications 7 ou 8, selon lequel ledit profilé est un profilé pressé.

9. Boîtier (1) selon la revendication 1, selon lequel ledit couvercle (2) est un isolant électrique.

10. Boîtier selon l'une des revendications 1 à 9, selon lequel lesdits abouts (3, 3', 4, 4') présentent des nervures isolantes de l'électricité en saillie entre les connexions pour augmenter la ligne de fuite.

11. Boîtier selon l'une des revendications 1 à 10, selon lequel le capot transparent en une-pièce peut être relevé.

12. Boîtier (1) selon la revendication 11, selon lequel l'assemblage des abouts (3, 4) présente un capot (37, 47) couvrant les éléments internes (36).

13. Boîtier (1) selon l'une des revendications précédentes avec une base allongée (5), selon lequel chacun des deux abouts est assemblé à chacune des arrêtes allongées de la base, selon lequel des éléments électroniques sont assemblés entre ces deux parties constituantes et sont couverts par ledit capot.

14. Boîtier selon la revendication 13, selon lequel un desdits abouts (3, 3', 4, 4') comporte des connexions électriques (35, 45) de toutes les phases entrantes du filtre et le second desdits abouts comporte des connexions électriques (35, 45) de toutes les phases sortantes du filtre.

15. Boîtier (1) selon l'une des revendications 13 ou 14, selon lequel ladite base (5) est en métal, selon lequel un pont thermique est prévu entre au moins une partie du filtre productrice de chaleur et ladite base.

16. Boîtier (1) selon l'une des revendications 13 ou 14, selon lequel une prise de terre est directement connectée à ladite base (5).

17. Boîtier (1) selon l'une des revendications précédentes avec des moyens d'accroche pour fixer ledit filtre antiparasite sur un rail (9).

18. Filtre antiparasite pour utilisation dans une installation de ligne électrique basse tension avec
• un montage de filtre,
• un boîtier (1) selon l'une des revendications précédentes pour contenir ledit montage de filtre au moins partiellement,
selon lequel lesdites connexions électriques (35, 45) sont connectées électriquement avec ledit montage de filtre à l'intérieur dudit boîtier (1).
